(19)

Europäisches
Patentamt

European
Patent Office

Office européen
des brevets

(11)  **EP 2 763 261 A1**

(12)  **EUROPEAN PATENT APPLICATION**
published in accordance with Art. 153(4) EPC

(43) Date of publication:
**06.08.2014 Bulletin 2014/32**

(21) Application number: **12835703.5**

(22) Date of filing: **07.08.2012**

(51) Int Cl.:
***H02J 3/00*** (2006.01)

(86) International application number:
**PCT/JP2012/070063**

(87) International publication number:
**WO 2013/046938 (04.04.2013 Gazette 2013/14)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **26.09.2011   JP 2011209757**

(71) Applicants:
  • **Hitachi, Ltd.**
    **Tokyo 100-8280 (JP)**
  • **The Kansai Electric Power Co., Inc.**
    **Osaka-shi**
    **Osaka 530-8270 (JP)**

(72) Inventors:
  • **YAMANE Kenichiro**
    **Tokyo 100-8280 (JP)**

  • **WATANABE Masahiro**
    **Tokyo 100-8280 (JP)**
  • **ADACHI Masahiro**
    **Ibaraki 319-1293 (JP)**
  • **MINAMI Masahiro**
    **Osaka 530-8270 (JP)**
  • **MATSUURA Yasuo**
    **Osaka 530-8270 (JP)**
  • **MORITA Tomohiko**
    **Osaka 530-8270 (JP)**

(74) Representative: **Beetz & Partner**
    **Patentanwälte**
    **Steinsdorfstraße 10**
    **80538 München (DE)**

(54)   **POWER SYSTEM STATE ESTIMATION DEVICE AND POWER SYSTEM USING SAME**

(57)    A power state of any point of a power system is estimated with high accuracy to appropriately perform monitoring of the state of the entire power system. A power system state estimation device is provided which includes a power system data database which holds node information indicative of positions in the power system and facility information including sensors in association with each other, a sensor data database which holds the output of the sensors, an estimation environment setting unit which determines a sensor to be used when a power state at a particular node is estimated, using the information of the power system data database, and a state estimation unit which in correspondence to the sensor used at the particular node determined by the estimation environment setting unit, obtains the output of the sensor from the sensor data database and performs state estimation for the entire power system.

**FIG. 1**

EP 2 763 261 A1

## Description

Technical Field

The present invention relates to a power system state estimation device which in order to properly perform monitoring of the state of the entire power system, estimates a power state of any point of the power system with high accuracy, using measurement information of each sensor, and a power system using the same.

Background Art

Regarding a power system, there has recently been an increasing demand for maintenance of the frequency and voltage at the introduction of a distributed power supply and efficient use of equipment in a power company. Therefore, the need to manage the power state of the voltage, current or the like representing the actual conditions of the power system is further increasing.

In the power state management, the power state of any point of the power system has been estimated by a power flow calculation or a power state calculation method called state estimation, using measurement information of each sensor for measuring a power state, which is provided at a limited point in the power system.

As the background art in the present technical field, there has been described in a Patent Literature 1 that "in the voltage management of each distribution line and operation control, the locations to install measuring instruments necessary to grasp the voltage distribution of the distribution line and the power flow state can be determined such that the best effect (such as the accuracy of a distribution line state calculation) is obtained in a minimum number".

Further, there has been described in a Patent Literature 2 that "the power flow state of a power distribution system and the error of each measuring device are estimated together from voltage/current measurement values of the power distribution system".

Furthermore, there has been described in a Patent Literature 3 that "there is provided a state estimation method of a power system, which formulates the weights given to each observation value and reliably converges even in a system having a large variation in impedance".

Citation List

Patent Literature

PTL 1: Japanese Patent Application Laid-Open No. 2008-72791
PTL 2: Japanese Patent Application Laid-Open No. 2008-154418
PTL 3: Japanese Patent Application Laid-Open No. 63-73831

Summary of Invention

Technical Problem

Considering these known background arts, any of the Patent Literatures 1 through 3 has means for calculating the power state on the basis of the measurement information of the sensors. Therefore, the state estimation accuracy of the power system depends on the sensors. Preferably, a lot of sensors of high accuracy are arranged in the power system. Further, there is desired one higher in accuracy as the estimation method.

For the sensors, in the Patent Literature 1 of them, the optimal installation location is determined in consideration of the estimation accuracy of each power state and cost when adding the sensor in the power system. Further, in the Patent Literature 2, in order to make a high-accuracy operation, the amount of correction of the estimated value is calculated in advance using the deviation between the measurement information of the sensor and the estimated value by the power state calculation, and the estimated value is modified using the correction amount.

However, even in both of the Patent Literatures 1 and 2, the measurement information on all sensors installed in the power system has been uniformly used. Therefore, the estimation accuracy may vary, but this problem is not taken into consideration.

Variation examples are introduced. For example, the estimation accuracy of the voltage is in no small degree related to the power factor that is one of the measurement information of the sensor. Therefore, in an operating time zone of a plant large in load, the power factor near the plant may exhibit characteristics (load characteristics) such as singular values greatly different from other places on the system. Further, when a phase advance capacitor for power factor adjustment is introduced in the factory, singular values rather than specific in the operating time zone may exhibit in a non-operating time zone in reverse.

However, in the power state calculation when only fewer sensors are installed in the system, there is a case where the calculation is performed using information of the singular value as a representative value of a section sandwiched by the sensors. When interpolating the value of the section sandwiched by the sensors, it is considered that if any of the sensors before and after the same exhibits the characteristics such as the singular value, variations occur in the power state estimation value accuracy of the entire power system.

In the Patent Literature 3, a convergent solution is obtained without uniformly using measurement information for all sensors installed in the power system by allowing the measurement information of each sensor to have a weight.

However, the Patent Literature 3 is intended to change the weight depending on the impedance (magnitude fixed according to the power system) of a line branch. The relative weight between the sensors is, so to speak, fixed. Further, the Patent Literature 3 is similar to the Patent Literatures 1 and 2 in that the weight is not brought to zero since the impedance is not zero in the actual power system, and the measurement information for all sensors are used.

As described above, when the load characteristics change dynamically, it is considered that it is difficult to dynamically cope therewith inclusive of the non-use of the measurement information for some sensors.

Thus, an object of the present invention is intended to solve the above problems and is to provide a power system state estimation device which in order to properly perform monitoring of the state of the entire power system, estimates a power state of any point of the power system with high accuracy, using measurement information of some of sensors, and a power system using the same.

Solution to Problem

The power system state estimation device according to the present invention made to solve the above problems and the power system using the same are characterized in that in a power system having a plurality of sensors for measuring a power state, a sensor exhibiting a peculiar tendency is identified and the power state of any point of the power system is estimated using a sensor excluding the corresponding sensor. A method for identifying a sensor exhibiting a peculiar tendency is proposed.

Specifically, a power system state estimation device is configured as follows:

There is provided a power system state estimation device having a plurality of sensors disposed in respective points of a power system and estimating a state of the power system using the output of the sensors, which includes a power system data database which holds node information indicative of positions in the power system and facility information including the sensors in association with each other, a sensor data database which holds the output of the sensors therein, an estimation environment setting unit which determines a sensor to be used when a power state (in particular, reactive power) at a particular node is estimated, using the information of the power system data database, and a state estimation unit which in correspondence to the sensor used at the particular node determined by the estimation environment setting unit, obtains the output of the sensor from the sensor data database and performs state estimation for the entire power system. The estimation environment setting unit includes a sensor identifying unit for identifying that the sensor installed in the power system is a sensor exhibiting a peculiar tendency, and a sensor changing unit for changing a sensor used to estimate a power state (in particular, reactive power) at a node corresponding to the identified sensor.

Further, a power system is configured as follows:

There is provided a power system including a plurality of sensors disposed in respective points of a power system, a power state control device disposed in each point of the power system and capable of controlling a power state of the power system, a power system state estimation device which estimates a power system state using the output of the sensors, and a power system control central device which provides an operation signal to the power state control device in response to the power system state from the power system state estimation device, characterized in that the power system state estimation device includes a power system data database which holds node information indicative of positions in the power system and facility information including the sensors in association with each other, a sensor data database which holds the output of the sensors therein, an estimation environment setting unit which determines a sensor to be used when a power state at a particular node is estimated, using the information of the power system data database, and a state estimation unit which in correspondence to the sensor used at the particular node determined by the estimation environment setting unit, obtains the output of the sensor from the sensor data database and performs state estimation for the entire power system, and the estimation environment setting unit includes a sensor identifying unit for identifying that the sensor installed in the power system is a sensor exhibiting a peculiar tendency, and a sensor changing unit for changing a sensor used at a node corresponding to the identified sensor. Advantageous Effects of Invention

According to the present invention, in order to properly perform monitoring of the state of the entire power system, the power state of any point of the power system is estimated using the measurement information of the remaining sensors excluding the sensor exhibiting the peculiar tendency, thereby enabling estimation thereof with high accuracy.

According to an exemplary embodiment, since the accuracy of the state estimation is improved, it becomes possible to support a suitable introduction plan of system facilities such as pole transformers, SVR, etc. It is thus possible to improve the utilization efficiency of the facilities.

Further, according to an exemplary embodiment, the optimum control amount of each control device is determined using the estimated power state. As a result, it is possible to reduce the amount of power loss in the power system and the amount of deviation from the specified range of the voltage. The quality of power can hence be maintained.

Brief Description of Drawings

Figure 1 is a configuration diagram of a power system state estimation device.
Figure 2 is a diagram showing a typical example of a distribution power system up to a load from a substation.
Figure 3 is a power system diagram schematically showing the power system of Figure 2 by nodes and branches.
Figure 4 is a diagram showing an example of power system data related to the nodes.
Figure 5 is a diagram showing an example of power system data related to the branches.
Figure 6 is a diagram showing an example of sensor data held in a sensor data database.
Figure 7 is a diagram showing first estimated environmental data as an example of estimated environmental data.
Figure 8 is a diagram showing second estimated environmental data as an example of estimated environmental data.
Figure 9 is a diagram showing third estimated environmental data as an example of estimated environmental data.
Figure 10 is a diagram showing an example of group classification of sensors by a clustering method.
Figure 11 is a diagram showing the idea of calculating a power state of any position by linear interpolation.
Figure 12 is a diagram showing a state estimation calculation method using a power equation.
Figure 13 is a diagram showing a configuration of a power system according to an example 2.
Figure 14 is a diagram showing an example of a method for calculating a control amount of each device that configures the power system.

Description of Embodiments

Exemplary embodiments of the present invention will hereinafter be described using the drawings. In an example 1, a description will be made of an example of a power system state estimation device 3 which estimates a power state of any point of a power system using measurement information of a sensor. In an example 2, a description will be made of an example of a power system using the power system state estimation device 3.

<Example 1 >

In the present example, a description will be made of an example of a power system state estimation device 3 that estimates a power state of any point of a power system using measurement information of a sensor. However, before its description, a description will be made of a typical power system in which the power system state estimation device 3 is installed.

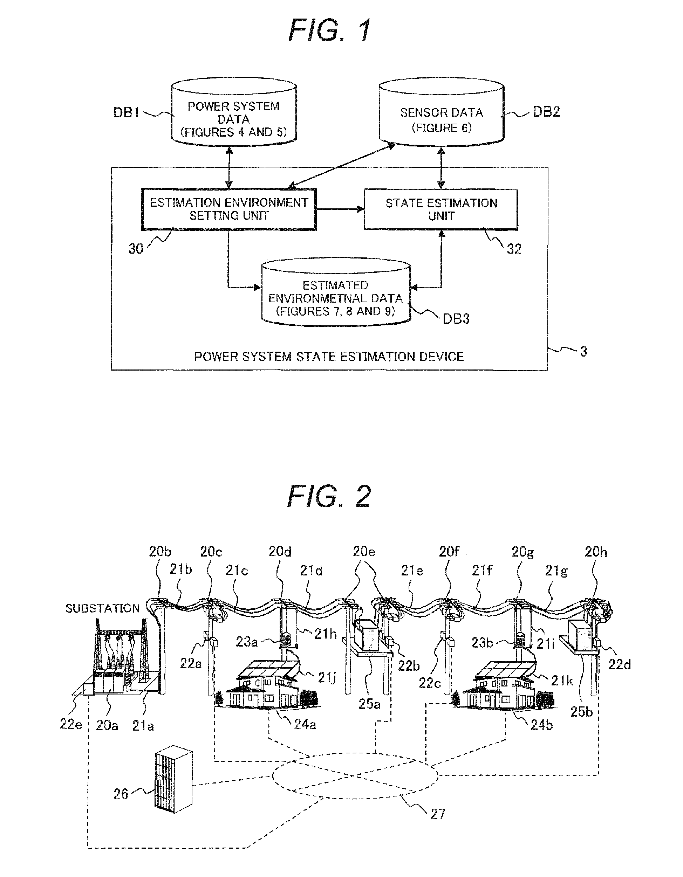

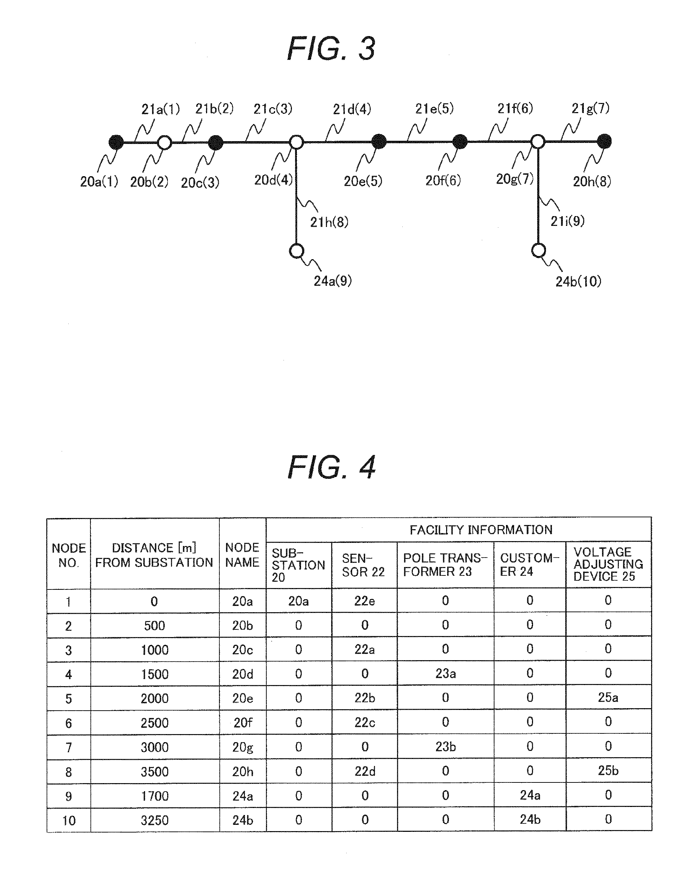

An example of the typical power system in which the power system state estimation device 3 of the present invention is installed is shown in Figures 2 and 3. First, Figure 2 shows a typical example of a distribution power system up to a load from a substation.

In this figure, 20 is a node that represents a point. For example, a node indicating the installation location of a transformer of a substation is 20a, and nodes each indicating the installation location of a utility pole are from 20b to 20h. Incidentally, the utility pole is appropriately provided with devices such as a sensor 22, a pole transformer 23, a voltage adjusting device 25, etc. Further, a sensor 22e is installed in the transformer of the substation. Therefore, for example, the node 20c of the utility pole equipped with the sensor 22a can also be represented as the node of the installation point of the sensor 22a. Likewise, the node 20d of the utility pole equipped with the pole transformer 23a can be expressed as the node of the pole transformer 23a, and the node 20e of the utility pole equipped with the voltage adjusting device 25a can be expressed as the node of the voltage adjusting device 25a.

Further, in this figure, 21 represents a branch that connects between the nodes. Thus, the branch in the power system represents a transmission/distribution line.

Moreover, in Figure 2, 24 is a customer connected to the power system. Thus, the customer 24 can also be expressed by a node indicative of a point. In the example of the drawing, 24a and 24b are nodes each indicative of a customer's location.

Figure 3 is a power system diagram schematically showing the power system of Figure 2 by the nodes 20 and the branches 21. That is, there have been shown nodes (20b through 20h) indicating the installation locations of a plurality of utility poles serially disposed toward the load side as viewed from the node 20a indicative of the position of the transformer of the substation. Further, the nodes 24a and 24b for the customers have been described with respect to the nodes (20b and 20h) each indicative of the installation location of the utility pole. The branches connect between the adjacent nodes.

Comparing Figures 2 and 3, for example, the sensor 22, the pole transformer 23 and the voltage adjusting device 25 are included and represented in Figure 2, but not shown in Figure 3. These are locally in the same as the pole node 20. Thus, they are located as attached equipment of the pole node.

In Figure 2, a communication network 27 is provided between the pole nodes (20c, 20e, 20f and 20h) each loaded with the sensor 22 and the transformer node 20a of the substation and between the customer nodes (24a and 24b) targeted for measurement of AMI (Advanced Metering Infrastructure) and a power system information collecting device 26. Thus, in the power system information collecting device 26, Γ are collected in Figure 3 as to information a on power states of the voltage, current, power factor, phase and the like at each point of the power system. Alternatively, the information a is generated by post-collection processing. Incidentally, the pole nodes (20c, 20e, 20f and 20h) each equipped with the sensor 22, and as with the transformer node 20 • ⌟ are described with black circles.

Figure 1 is an example of a configuration diagram of the power system state estimation device 3 according to the present embodiment. The power system state estimation device 3 is comprised of an estimation environment setting unit 30, an estimated environment data database DB3, and a state estimation unit 32. Further, the power system state estimation device 3 is connected to a sensor data database DB2 and a power system data database DB1 and performs a predetermined arithmetic operation using these data. Of these, the sensor data stored in the sensor data database DB2 is sensed information of the sensor 22 collected to the power system information collecting device 26 through the communication network 27 of Figure 2 and obtained from the power system.

The flow of rough processing in the power system state estimation device 3 will next be described. First, the estimation environment setting unit 30 reads the power system data related to the facility (facility such as the substation transformer 20, pole transformer 23, voltage adjusting device 25, customers 24, or the like inclusive of the sensor 22) that makes up the power system targeted for state monitoring from the power system data database DB1. In addition, the sensor to be used when performing the power state estimation is set. The state estimation unit 32 reads the measurement information of the sensor set in the estimation environment setting unit 30 from the sensor data database DB2. Further, using this data, the power state (current, voltage, phase or the like) of any point of the power system is calculated by the state estimation calculation.

The present invention is characterized by the processing of the estimation environment setting unit 30. The following description will be made centering on the estimation environment setting unit 30. A process in the state estimation unit 32 can be achieved using the existing known technique through the use of the information from the sensor set by the estimation environment setting unit 30.

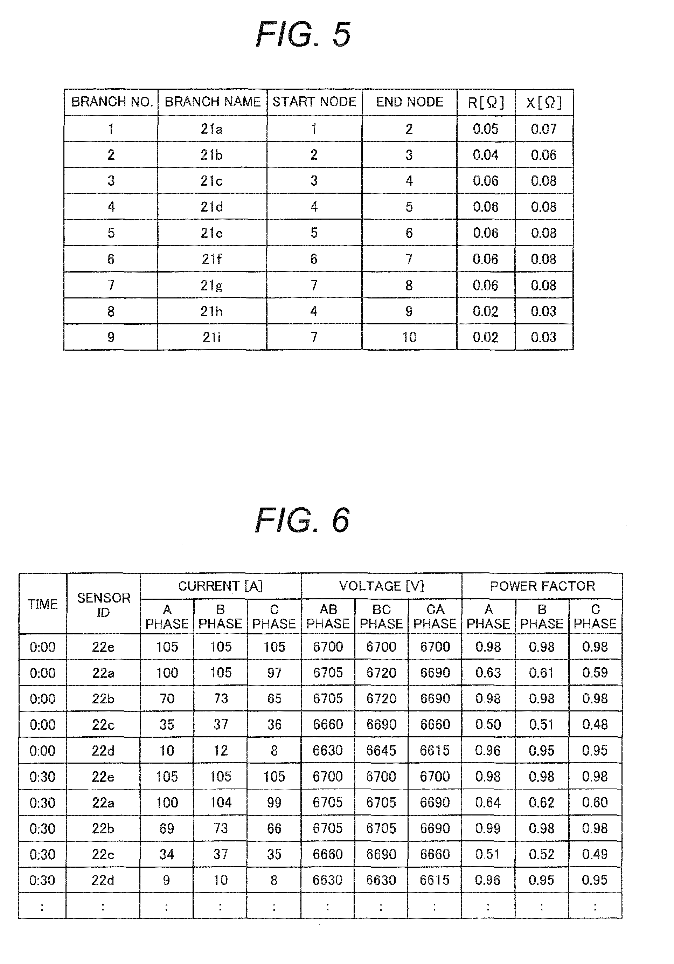

An example of power system data used in the estimation environment setting unit 30 is shown in Figures 4 and 5.

The power system data is data set in advance according to the configuration of the power system and stored in the power system data database DB1. Incidentally, the data in the typical power system shown in Figures 2 and 3 is shown as the data of Figures 4 and 5.

The data of Figure 4 is an example of the power system data related to the nodes and shows a correspondence relation between each node (20, 24) indicative of the point and the facility provided in this position. For example, a node 20a defined as a node No. 1 is distant 0 meters from the substation and stored in association with the substation 20a and the sensor 20e as a facility. Likewise, a node 20b defined as a node No. 2 is a utility pole that is present at a position distant 500 meters from the substation. Since there are not provided in this position, the facilities such as the substation transformer 20, the pole transformer 23, the voltage adjusting device 25, the customer 24, the sensor 22, etc., facility information is not stored in association.

Further, a node 20e defined as a node No. 5 is distant 2000 meters from the substation and stored in association with the sensor 22b and the voltage adjusting device 25a as a facility. A node 24a defined as a node No. 9 is distant 1700 meters from the substation and stored in association with the customer 24a as a facility.

Incidentally, since the meaning of the description about other nodes in Figure 4 can easily be understood from the above description, a description about all examples of Figure 4 will be omitted. In Figure 4, however, it means that the corresponding facilities and equipment are not installed in the places where the columns up to the substation-voltage adjusting device have been brought to zero. The corresponding facilities and equipment are installed in the places where the columns up to the substation-voltage adjusting device become those other than zero. A device ID for identifying it is described.

The data in Figure 5 is an example of power system data related to the branches. Each branch 21 is defined by a start node and an end node. Information on the resistance R and reactance X of the transmission line of each branch, thus the corresponding portion is described side by side and stored. Incidentally, each of the start and end nodes is expressed using the node No. at the node name of Figure 4. The nodes Nos. used in Figure 4 are described in the nodes 20 and 24 of Figure 3 in parentheses.

Regarding how to read the data in Figure 5, for example, a branch name defined by a start node 3 and an end node 4 is 21c, and its branch No. is 3. It is possible to read from this table that the resistance R of the transmission line interval is 0.06 ($\Omega$) and the reactance X thereof is 0.08 ($\Omega$). Incidentally, the branch No. which has been used in Figure 4, is described in the branch 21 of Figure 3 in parenthesis.

Since other branches of Figure 5 can easily be understood from the above description, a description about all examples of Figure 5 will be omitted. According to this notation, the branch is comprised of the start and end nodes, and the impedance and the like and can grasp a connection relation between electric wires through the nodes. The power system data shown in Figures 4 and 5 are prepared in advance according to the relationship between the power system configuration of Figures 2 and 3 and its facilities and stored in the power system data database DB1. Further, the contents thereof are appropriately modified according to changes in the power system configuration or changes in the facility and equipment.

An example of the sensor data stored in the sensor data database DB2 of Figure 1 is shown in Figure 6. Incidentally, as the data of Figure 6, data in the typical power system shown in Figures 2 and 3 is shown. Further, the sensor 22 is grasped in association with the sensor ID used when the sensor is defined as the facility information of Figure 4. The data content of Figure 6 is information collected regularly by the power system information collecting device 26 and recorded together with time information.

The sensor data used in Figure 1 is data related to the power state (e.g., current, voltage, power factor, active power, reactive power or the like) measured on a regular basis by the sensor 22 installed in the power system of Figure 2. Here, in the example of Figure 4, the sensor 22 includes the sensor of the sensor ID22e defined by the node name 20a and the node No. 1, the sensor of the sensor ID22a defined by the node name 20c and the node No. 3, the sensor of the sensor ID22b defined by the node name 20e and the node No. 5, the sensor of the sensor ID22c defined by the node name 20f and the node No. 6, and the sensor of the sensor ID22d defined by the node name 20h and the node No. 8.

These sensors are connected to the power system information collecting device 26 through the communication network 27. The sensor data measured by the sensors are collected and stored in the sensor data database DB2 in the power system information collecting device 26. Incidentally, the power system state estimation device 3 manages various data related to the power system inclusive of the sensor data and the power system data.

In Figure 6 showing one example of the sensor data, for example, the information on the current, voltage and power factor measured by the sensors of the sensor IDs22e, 22a, 22b, 22c and 22d are stored in phase units. Further, the detection of these is executed as a constant cycle at the same time every 30 minutes, for example and stored.

The estimation environment setting unit 30 of Figure 1 creates and edits estimated environmental data using the power system data of Figures 4 and 5 prepared in advance. The estimated environmental data are parameters such as weights or the like for each sensor ID or sensor. The estimated environmental data are stored in the estimation environment data database DB3 and thereafter used to perform an estimation calculation of power states in the state estimation unit 32.

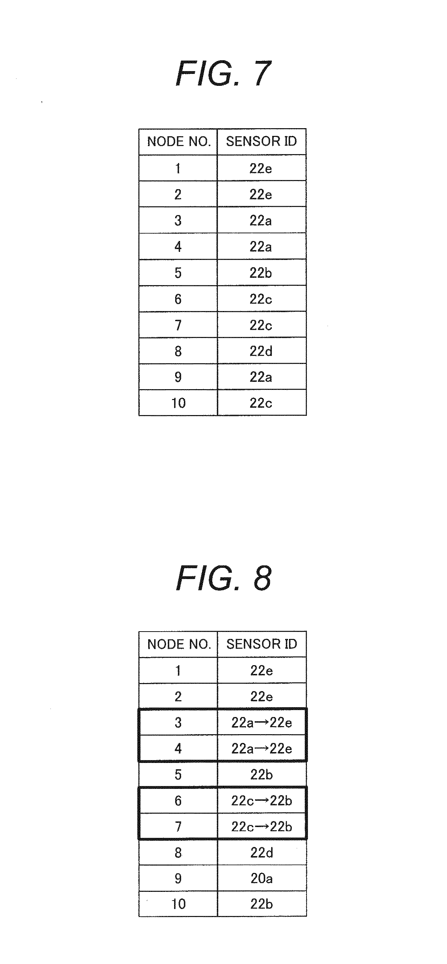

An example of the estimated environmental data is shown in Figures 7, 8 and 9. These estimated environmental data are a result product created and edited by the processing in the estimation environment setting unit 30 using the power system data of Figures 4 and 5 prepared in advance. The form of the estimated environmental data taken as the result product will first be explained herein. A processing procedure for creating the estimated environmental data will be described subsequently.

These estimated environmental data are constructed of the node number and the sensor ID in pairs. This is intended to show that supposing, for example, the load is calculated as the power state of the customer connected to each node, the measurement information of the sensor ID used upon this calculation is used.

In the first estimated environmental data shown in Figure 7, for example, the measurement information of the sensor 22e (sensor of substation) is used to calculate the reactive power of the customers connected to the nodes 1 and 2. The measurement information of the sensor 22a is used to calculate the reactive power of the customers connected to the nodes 3 and 4 (a specific calculation method will be described later). The same applies to other nodes too. The way of thinking about the first estimated environmental data defines that if a node is provided with a sensor, the output of the sensor at that position is used for estimation of the power state, and if a node is not provided with a sensor, the output of the sensor nearest the upstream side is used for estimation of the power state.

In the second estimated environmental data shown in Figure 8, a sensor exhibiting a peculiar tendency is specified and not used, and other sensors are used instead. In the example of Figure 8, the sensor 22a of the node 3 is not used when the sensor 22a is a sensor exhibiting a peculiar tendency, and instead a change in sensor is made to use the output of the sensor 22e nearest the upstream side for estimation of the power state. The sensor of the node 4 on the downstream side of the node 3 is also changed to the sensor 22e in accordance with this change.

In another example illustrative of the change in the combination in Figure 8, the sensor 22c of the node 6 is not used when it is a sensor exhibiting a peculiar tendency, and instead a change in sensor is made to use the output of the sensor 22b nearest the upstream side for estimation of the power state. The sensor of the node 7 on the downstream side of the node 6 is also changed to 22b according to this change.

Incidentally, here, the "sensor exhibiting the peculiar tendency" is a sensor which does not show the correct value due to the environment in which the sensor is put, or shows a peculiar tendency when compared with the average sensor and which has a circumstance such as nonuniformity of the measurement environment. It is not a malfunction of the sensor. For example, the power factor for large customers vicinity may indicate aspects different from the surroundings under the influence of operating states or introduced facilities (phase advance capacitors or the like) for large customers such as plants. Therefore, with the exception of this sensor, the power state estimation of each portion is performed by the combination of Figure 8.

For the identification of the sensor exhibiting the peculiar tendency, it will be described later more specifically inclusive of a determination method. Incidentally, the availability of the load (active power P, reactive power Q) of the customers connected to each node will be described later as the description of the function of the state estimation unit 32.

Thus, Figure 8 related to the second estimated environmental data shows that upon the reactive-power calculation of the nodes 3 and 4 and the nodes 6 and 7, the measurement information of the sensors 22e and 22b are used instead without using the measurement information (power factor) of the sensors 22a and 22c, respectively. That is, it has been proposed that when the power factor is measured, for example, all power factor sensors are used with some sensors being identified, rather than being used for the state estimation.

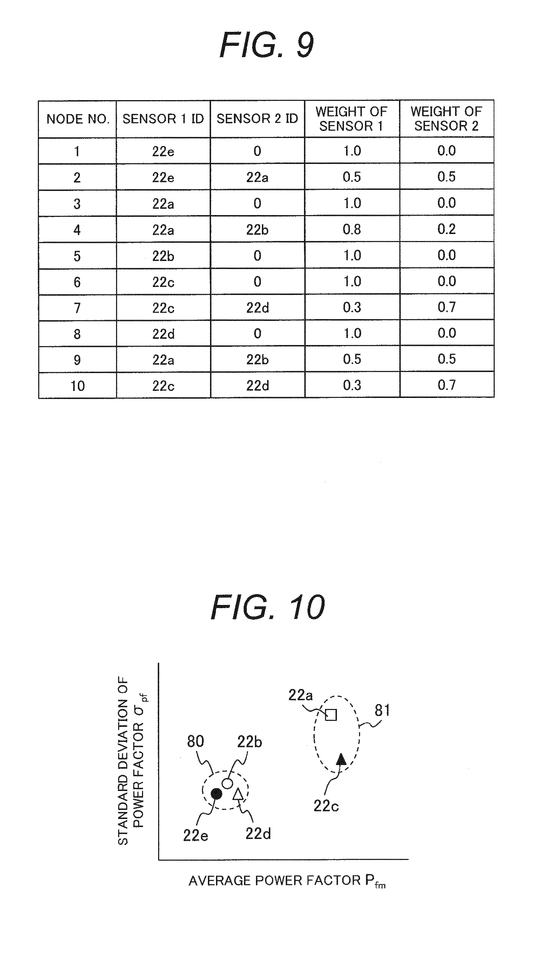

In Figure 9 showing third estimated environmental data, when calculating the reactive power of the customers connected to each node, there are used measurement information of a plurality of sensor IDs weighted and averaged using the set weights. The weights are assigned such that the sum thereof becomes 1 for each node.

In the third estimated environmental data of Figure 9, the sensors each used in the node having the sensor are only the sensors each installed in the corresponding point. The nodes Nos. 1, 3, 5, 6 and 8 correspond to this. In contrast, both of sensors located immediately upstream and downstream are used as the sensors used in the nodes (node Nos. 2, 4, 7, 9 and 10) each having no sensor.

For example, the node No. 2 means that both of the immediately upstream sensor 22e and the immediately downstream sensor 22a are used, and a value obtained by multiplying their outputs by 0.5 as weights (uniform loads) respectively and adding the same is used as a measurement signal at this node. Further, for example, the node No. 4 means that both of the immediately upstream sensor 22a and the immediately downstream sensor 22b are used, and a value obtained by multiplying their outputs by 0.8 and 0.2 as different weights (non-uniform loads) respectively and adding the same is used as a measurement signal at this node. What the weight distribution should be done is suitably determined in consideration of the environment of the system.

Incidentally, it is needless to say that when obtaining the third estimated environmental data, some of the sensors descried in Figure 8 are not used and instead a change in sensor can be made to use the immediately upstream and downstream sensors.

A description will next be made of a method of creating the above estimated environmental data in Figures 7, 8 and 9 (estimated environmental data creation). This creating method is executed inside the estimation environment setting unit 30.

<First estimated environmental data creating method: creating method of first estimated environmental data in Figure 7>

In this case, the estimated environmental data may be determined in advance by a user such as an administrator of the power system or the like and stored in a predetermined file format. The estimation environment setting unit 30 has the function of supporting the file creation of estimated environmental data such as text editors. In this case, the content of the file format prepared in advance is taken as the first estimated environmental data as it is.

<Second estimated environmental data creating method: creating method of second estimated environmental data in Figure 8>

As a premise of this description, a consumer ID (although not described in Figure 4) is included in the node data of the power system data in Figure 4. Further, a customer type is included as information on each customer. Here, the customer type refers to the industrial category or type of customers such as the industry, commerce, housing or the like.

The estimation environment setting unit 30 determines the percentage of the entire power system for each customer type and also determines a representative customer type for each sensor in consideration of the type of customers therearound. Specifically, for example, 70% of all customers are taken to be residential areas in the power system of Figures 2 and 3, and the industry and commerce are respectively taken to be 15%. Individually, for example, the periphery of the sensor 22a is assumed to be an industrial zone, the periphery of the sensor 22c is assumed to be a commercial zone, and the periphery of each sensor other than those is assumed to be a residential area.

Here, the periphery of the sensor means that the straight line distance from the sensor or the extension distance of each wire up to the customer from the sensor is within a predetermined distance. At this time, the representative customer type of the power system is taken as the housing highest in proportion. The sensors (22e, 22b and 22d) in which the representative customer type is housing are selected, and the sensors (22a and 22c) for the other types are not selected. Here, the meaning of "not selected" is to avoid the use of the sensors (22a and 22c) in the table of the first estimated environmental data of Figure 7, resultingly obtain the second estimated environmental data through the table of Figure 8. Thus, the sensors of the same type as the representative customer type (residential area in this case) are used for the state estimation calculation in an industrial zone and a commercial zone in which the sensors (22a and 22c) are installed. As a result, it is possible to obtain the estimated solution of the entire power state stably and with satisfactory accuracy.

Based on the list of the sensors selected in the above-described manner, the sensor for calculating the reactive power of each of the customers connected to each node is determined. According to the method of determining the sensors for each node, for example, the closest sensor lying on the upstream side (on the substation side) of the target node is determined (excluding the sensors that are not selected above). For example, the sensor 22e is selected for the nodes 1 and 2 as it is. Since the sensor 22a is not selected for the nodes 3 and 4, the sensor 22e nearest on the upstream side is selected. As other nodes are determined in the same manner, the estimated environmental data of Figure 8 is created. In this way, the estimated environmental data can be created by selecting each sensor on the basis of the customer type.

Thus, in the second estimated environmental data creating method for creating the second environmental data in Figure 8, the sensors each exhibiting the peculiar tendency can be identified in consideration of the proportion of the entire power system for each customer type mentioned above or the customer type around the sensor for each sensor.

<Third estimated environmental data creating method: creating method of second estimated environmental data in Figure 8>

Although the second estimated environmental data of Figure 8 is obtained even in the present case, the third estimated environmental data creating method is different in derivation method from the second estimated environmental data creating method. The second estimated environmental data creating method was the idea of identifying the sensor exhibiting the peculiar tendency, based on the entire power system and the customer type around the sensor, but in the third estimated environmental data creating method, a statistical method is adopted. Specifically, a sensor exhibiting a peculiar tendency is identified by clustering based on the power state to be measured.

In this case, the estimation environment setting unit 30 refers to the sensor data in addition to the power system data. Here, as illustrated in Figure 6, the sensor data is the stored measurement information of the past predetermined period (which may include current data). Here, attention is given to, for example the power factor of the measurement information.

A power factor $P_f$ is measured every phase like a A-phase, a B-phase and a C-phase, but an example of handling the average value of three phases is shown as an example. That is, a three-phase average power factor is obtained for each time t·sensor. Incidentally, instead of the three-phase average value, the respective phases may be treated individually. Next, the three-phase average power factor is further averaged in the sensor unit, based on the so-obtained three-phase power factor ($P_f$ ((t)) for each time t·sensor to obtain an average power factor $P_{fm}$ ((equation 1)) for each sensor and a standard deviation $\sigma_{pf}$ ((equation 2)). Incidentally, n is the number of sensors.

[Equation 1]

$$P_{fm} = \frac{1}{n}\sum_{t=1}^{n} P_f(t) \qquad \cdots \quad (1)$$

[Equation 2]

$$\sigma_{pf} = \sqrt{\frac{1}{n}\sum_{t=1}^{n}(P_f(t) - P_{fm})^2} \qquad \cdots \quad (2)$$

Clustering (cluster analysis) is performed based on the so-obtained average power factor $P_{fm}$ and standard deviation $\sigma_{pf}$ for each sensor. The sensors are divided into several groups according to the characteristic distribution of the power factor.

As this sensor clustering method, for example, the K-means method may be used. An example of group classification of sensors by the clustering method is shown in Figure 10. The horizontal axis of Figure 10 is the average power factor $P_{fm}$, and the vertical axis thereof is the standard deviation $\sigma_{pf}$ of power factor. Each point plotted on the two-dimensional space in this Figure is based on the average power factor $P_{fm}$ and standard factor $\sigma_{pf}$ of each sensor obtained in the above-described manner.

The sensors are classified into groups of 80 and 81 when divided into two groups by the clustering method, based on this. The group 80 includes 22e, 22b and 22d, and the group 81 includes 22a and 22c. Further, it can be seen that 22e, 22b and 22d of the group 80 are located close to each other and high in the degree of showing the same output tendency, whereas 22a and 22 of the group 81 are relatively discrete and high in the degree of showing output tendencies different even as belonging to the group.

As a result, the group 80 becomes a majority that includes three sensors therein. The sensors 22e, 22d and 22d that belong to the group 80 are selected. It turns out that these selected sensors 22e, 22b and 22d are all sensors disposed around the residential area and different in output tendency from the non-selected sensors 22a and 22c lying in the industrial and commercial zones. Thus, the sensors placed under the characteristic distribution of similar power factors are used, thereby resulting in obtaining the estimated solution of the power state stably and with satisfactory accuracy. Based on the list of the sensors selected in this manner, the sensor for calculating the reactive power of each of the customers connected to each node is determined as with the second estimated environmental data creating example.

In the third estimated environmental data creating method, the second estimated environmental data of Figure 8 is created in the manner described above. In the present example, the two-dimensional space has been handled as the data used in clustering like the average power factor $P_{fm}$ and the standard deviation $\sigma_{pf}$, but in addition to the power factor, the current, voltage, active power, reactive power and the like may be used as information to be measured by the sensors and 1-dimension to 3-dimensinal or more spaces.

<Fourth estimated environmental data creating method: creating method of second estimated environmental data in Figure 8>

Also in the present case, the second estimated environmental data of Figure 8 is obtained. A derivation method used herein is of the statistical method adopted in the third estimated environmental data creating method. Specifically, a plurality of combinations of sensors are set, and a combination of sensors closest in average and variation to the entire distribution lines is selected on the basis of the power state measured in each combination.

The estimation environment setting unit 30 refers to the sensor data in addition to the power system data in a manner similar to the third estimated environmental data creating example. Even here, as with the third estimated environmental data creating example, attention is paid to the average value of the three-phase power factor of each measurement information, and the average power factor $P_{fm}$ for each sensor is obtained by the equation (1). Next, averaging is further performed for all sensors from the average power factor $P_{fm}$ thereby to obtain an average power factor $P_{fM}$ for all the sensors. The average power factor $P_{fM}$ for all the sensors is regarded as the representative power factor of the corresponding power system.

Next, among all the sensors, a combination of sensors used for the calculation of node reactive power is determined. In the present example, since there are five sensors (22a, 22b, 22c, 22d and 22e), the number of combinations of sensors is $2^5$-1 (= 31) ways (one or more sensors are used).

Then, the average power factor $P_{fm}$ (i) of each combination is calculated. Here, i is the number of the combination (1 to 31). Of the average power factor $P_{fm}$ (i) of each combination determined in this way, the combination of the sensors (less than or equal to a predetermined value in terms of a deviation) closer to the average power factor $P_{fM}$ for all the sensors is extracted one or more. Incidentally, the combinations using all the sensors are always extracted because of being close to the average power factor $P_{fM}$ for all the sensors (the deviation is zero).

For the respective combinations of the sensors extracted in this manner, the standard deviation $\sigma_{pf}$ of the average power factor ($P_f$ (t)) of each sensor is obtained by the equation (2) (however, the standard deviation is taken to be zero in the case of one sensor).

Then, the standard deviations of the extracted combinations of sensors are respectively compared, and the combination minimized in standard deviation is selected. When the combination minimized in the standard deviation exists in plural form, there is selected one in which the average power factor $P_{fm}$ (i) is closest to the average power factor $P_{fM}$ of all sensors. Thus, the sensors having the characteristics (comparable in average and variation) of the similar power factors are used, thus resulting in obtaining an estimated solution of a power state stably and with satisfactory accuracy.

Based on the list of the sensors included in the combination selected in this manner, the sensor for calculating the reactive power of each of the customers connected to each node is determined as with the second and third estimated environmental data creating examples. The estimated environmental data in Figure 8 is created in the above-described manner.

<Fifth estimated environmental data creating method: creating method of second estimated environmental data in Figure 8>

Also in the present case, the second estimated environmental data of Figure 8 is obtained. A derivation method used herein is of the statistical method adopted in the third and fourth estimated environmental data creating methods. Specifically, a plurality of combinations of sensors are set, and the power state at each evaluation point of the power system is calculated based on the power state measured by each combination. The combination is selected in which the deviation between the calculated value at the corresponding evaluation point and measurement data becomes minimum.

The estimation environment setting unit 30 refers to the sensor data in addition to the power system data in a manner similar to the fourth estimated environmental data creating example. Here, using respective three-phase average values of measurement information (three-phase current, voltage and power factor) for each sensor, an average value $S_j$ (t) thereof (average current $I_j$ (t), average voltage $V_j$ (t), average power factor $P_{fj}$ (t)) is calculated in a manner similar to the equation (1).

Here, j indicates the sensor. Next, of all the sensors, the combination of the sensors used in the calculation of node reactive power is determined. In the present example, since there are five sensors (22a, 22b, 22c, 22d and 22e), the number of combinations of sensors is $2^5$-1 (= 31) ways (one or more sensors are used).

Then, the estimated environmental data in each combination are respectively created. The creating method of the estimated environmental data is similar to the second estimated environmental data creating method. In determining the sensor for each node, the sensor may be taken to be the closest sensor that is on the upstream side (substation side) of a target node, for example.

Next, for each combination, the power state estimation calculation to be executed in the state estimation unit 32 to be described later is carried out using the created estimated environmental data and sensor data. Thus, for each combination, the estimated value of the power state (current, voltage, power factor, active power, reactive power or the like) of any point of the power system is calculated.

Then, for an evaluation point j (one or more sensor installation points) on the power system defined in advance for a predetermined period, sensor data $S_j$ (t) at a time t is taken to be true, and the sum of deviations between the sensor data and a calculated power state estimation value $E_{ij}$ (t) is calculated as an evaluation value $Y_i$ of a combination i by an equation (3), for example.

[Equation 3]

$$Y_i = \sum_i \sum_j w_j (E_{ij}(t) - S_j(t))^2 \qquad \ldots \quad (3)$$

Here, $w_j$ is a weight set for each sensor data. The sensor data $S_j$ and the power state estimation value $E_{ij}$ are a power state of the same type, but may be plural with no need to be necessarily single.

For example, when two types of current and voltage are used, the evaluation value $Y_i$ becomes a square sum of respective deviations between the current and voltage. Comparing the evaluation values for each combination calculated in this way, a combination minimal in evaluation value is extracted.

This results in the use of such a sensor that a power state estimation value minimal in deviation from the sensor data is obtained. As a result, it is possible to obtain an estimated solution of a power state stably and with good accuracy. Based on the list of the sensors included in the combination selected in this manner, the sensor for calculating the reactive power of each of the customers connected to each node is determined in a manner similar to the second through fourth estimated environmental data creating examples. The estimated environmental data such as shown in Figure 8 is obtained in the above-described manner.

The foregoing has described the several techniques for obtaining the estimated environmental data in Figure 8, but it is preferable to further reflect several items thereto upon this realization.

For example, the estimated environmental data created in the second through fifth estimated environmental data creating methods and stored in the estimated environment data database DB3 should not necessarily be the same for a whole 365 days. It may be possible to create estimated environmental data every day of the week or for each time zone in consideration of an operating period of a plant, commerce or the like, etc.

Alternatively, the estimated environmental data may dynamically be created according to the magnitude of load power (e.g., active power transmitted from the substation) flowing through the power system. The estimated environmental data are created divided into, for example, two cases where the active power of the substation exceeds a predetermined threshold value (heavy load) and is a threshold value or less (light load). Incidentally, the number of estimated environmental data may be increased by increasing the number of threshold values.

By doing as mentioned above, it is possible to perform the state estimation calculation with higher accuracy since the estimated environmental data matched with the load state of the power system is created.

Next, returning to Figure 1, a description will be made of the processing of the state estimation unit 32, which is executed using the estimated environmental data determined in the above-described manner. The state estimation unit 32 calculates the estimated value of the power state of any point of the power system, using the estimated environmental data created by the estimation environment setting unit 30 and stored in the estimation environment data database DB3, and the sensor data stored in the sensor data database DB2.

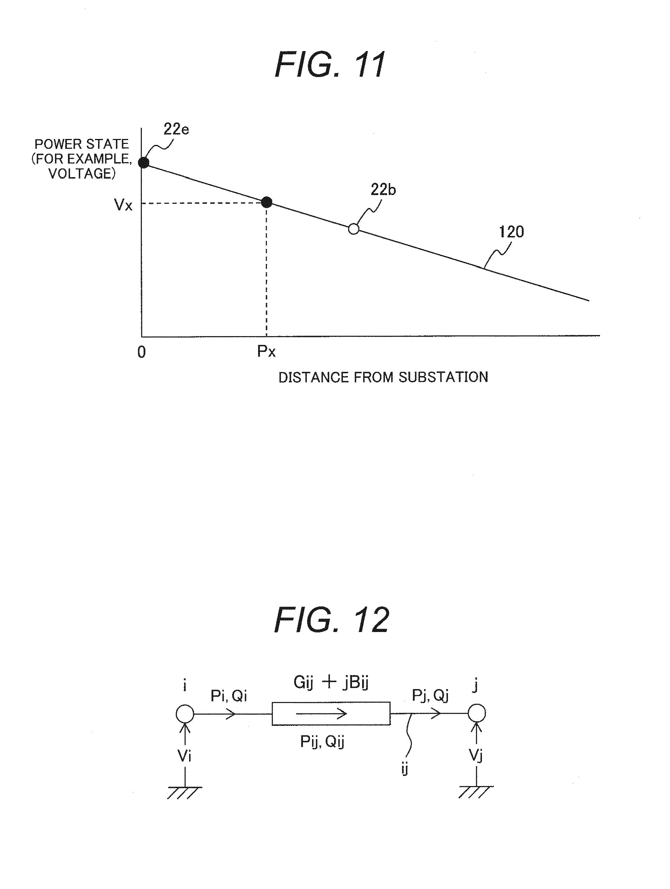

Although there are several in the way of the state estimation calculation, there is known as the simplest method, one for calculating a power state 120 of any position by linear interpolation such as interpolation, extrapolation or the like, using the position (distance from the substation) of such a sensor as shown in Figure 11 and each power state included in the sensor data stored in the sensor data database DB2.

Incidentally, in the same drawing, the horizontal axis indicates the distance from the substation, and the power state of the vertical axis is for example, a voltage. When the voltages at two points (22e and 22b) are being measured, a straight line 120 connecting these voltages is assumed, and the voltage Vx of any point Px is estimated by linear interpolation such as interpolation or extrapolation.

As another state estimation calculating method, a method using a power equation will be explained using a model system shown in Figure 12. In Figure 12, i and j respectively indicate nodes, and ij indicates a branch that connects the nodes i and j. G and B respectively indicate the conductance and susceptance of the branch ij.

In the power equation, the formulation of the node (injected power) is first performed. Assuming that a phase difference obtained when the phase angles of the nodes i and j are respectively taken to be $\theta_i$ and $\theta_j$, is $\delta$ ($= \theta_i - \theta_j$), the active power $P_i$ and reactive power $Q_i$ of the node i are represented by equations (4) and (5) respectively.

[Equation 4]

$$
\begin{aligned}
P_i &= \sum_j |V_i||V_j|(G_{ij}\cos\delta + B_{ij}\sin\delta) \\
&= |V_i|^2 G_{ij} + \sum_{j\infty i} |V_i||V_j|(G_{ij}\cos\delta + B_{ij}\sin\delta)
\end{aligned}
\qquad \cdots \ (4)
$$

[Equation 5]

$$
\begin{aligned}
Q_i &= \sum_j |V_i||V_j|(G_{ij}\sin\delta - B_{ij}\cos\delta) \\
&= -|V_i|^2 B_{ij} + \sum_{j\infty i} |V_i||V_j|(G_{ij}\sin\delta - B_{ij}\cos\delta)
\end{aligned}
\qquad \cdots \ (5)
$$

Next, the formulation of the branch (line power) ij is performed. The active power $P_{ij}$ and reactive power $Q_{ij}$ of the branch ij that connects the node i and j are respectively represented by equations (6) and (7).

[Equation 6]

$$
P_{ij} = G_{ij}|V_i|^2 - |V_i||V_j|(G_{ij}\cos\delta + B_{ij}\sin\delta) \qquad \cdots \ (6)
$$

[Equation 7]

$$
Q_{ij} = -B_{ij}|V_i|^2 - |V_i||V_j|(G_{ij}\sin\delta - B_{ij}\cos\delta) \qquad \cdots \ (7)
$$

Next, the formulation of a state estimation calculation will be described. The state estimation calculation is the problem of determining a state variable x that satisfies the equation (8).
[Equation 8]

$$z = h(x) + v \qquad \qquad \ldots (8)$$

where

z: observation value (magnitude of voltage measured by sensor or AMI, node injection power, and power state of branch),
h: non-linear function ($P_{ij}$, $Q_{ij}$, $P_i$ and $Q_i$ and voltage $V_i$ formulated in the above),
x: state variable ($V_i$, $\delta_{ij}$), and
v: noise included in observation value.

Here, the noise v included in the observation value is regarded as white noise.

In addition, the observed value of the load (active power $P_i$, reactive power $Q_i$) of the customers connected to each node will be described. Since the active power is measured by AMI (Advanced Metering Infrastructure) by which it is measured separately, its measured value may be used. Since the reactive power is not measured by AMI (AMI measures only active power because it is mainly used for the purpose of automatic metering), the reactive power is determined by an equation (9) from the active power $P_i$ measured by AMI and the power factor $P_f$ measured by the sensor 22 (however, the sign of the reactive power is taken to be positive in the case of a lagging power factor and negative in the case of a leading power factor).

[Equation 9]

$$Q_i = P_i \cdot \sqrt{\frac{1}{P_f^2} - 1} \qquad \qquad \ldots (9)$$

Thus, in order to calculate the equivalent of a measured value of the load (reactive power) of the node, the power factor information of the sensor specified by the estimated environmental data is used.

Upon determining a solution to the state estimation calculation, the initial values of state variables $V_i$ and $\delta_{ij}$ are taken to be 1.0 [pu] and 0.0 [deg] respectively, and their h (x) are obtained by the equations (4) through (7). Here, in the state estimation calculation using the least squares method, an objective function J (x) in an equation (10) is minimized.

[Equation 10]

$$J(x) = \sum_{i=1}^{m} w_i (z_i - h_j(x))^2 \qquad \qquad \ldots (10)$$

Thus, such state variables x (voltage $V_i$ and phase difference $\delta_{ij}$) as to minimize the sum of squares of weighted deviations of all observation values are determined. Power for the node and branch are determined by the equations (4) through (7) using the state variables. Further, current $I_{ij}$ is also determined by an equation (11).

$$I_{ij} = \frac{\sqrt{3} V_i \cos \delta_{ij}}{P_{ij}} \qquad \qquad \ldots (11)$$

As described above, the various power states (active power, reactive power, voltage and phase of each node, and active power, reactive power and current of each branch, etc.) are determined in such a manner that the sum of the errors of the sensor data becomes minimal. Therefore, the power state does not necessarily match with the sensor data.

This is because on the assumption that the measurement errors and the errors due to the deviation of the measurement timing, etc. are included in the sensor data, the whole power state is estimated in such a manner that the power states of the entire power system are made coherent well.

As described above, the state estimation unit 32 can calculate the estimated value of the power state of any point in the power system to minimize the deviation between the estimated environmental data created by the estimation environment setting unit 30 and the sensor data, using the estimated environmental data and the sensor data.

As described above, if the power system state estimation device of the present invention is used, the state of any point of the power system can be estimated with high accuracy using the measurement information of some of the sensors in order to take into consideration the dynamic load characteristics of the power system and appropriately perform the monitoring of the status of the entire power system. Further, since the accuracy of the state estimation is improved, it becomes possible to support a suitable introduction plan of system facilities such as pole transformers, SVR, etc. It is thus possible to improve the utilization efficiency of the facilities. Incidentally, there is no choice but to introduce overspec facilities each given a margin of an error when the accuracy is poor.

<Example 2>

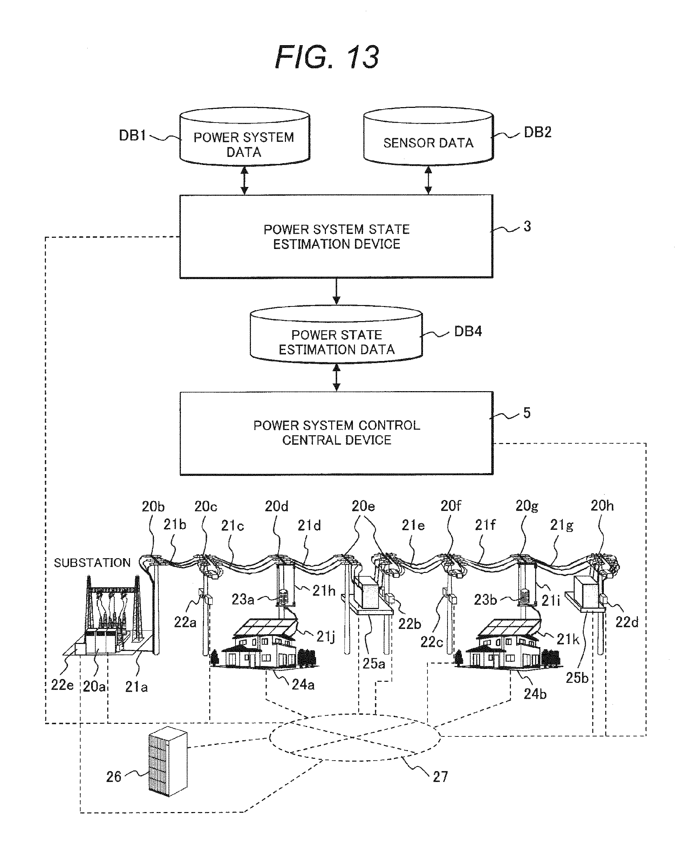

In the present example, a description will be made of an example of a power system using a power system state estimation device 3. Figure 13 is an example of a configuration diagram showing a power system according to the example 2. Here, in the power system state estimation device 3 of Figure 1, the description of parts each having a configuration given the same reference numerals shown in Figure 1 already described and the same function will be omitted.

As shown in the drawing, the power system using the power system state estimation device 3 is comprised of a power system data database DB1, a sensor data database DB2, the power system state estimation device 3, a power state estimation data database DB4, a power system control central device 5, a power system comprised of substations 20 and sensors 22, voltage adjusting devices 25, customers 24, pole transformers 23, etc., a power system information collecting device 26, and a communication network 27.

The devices constituting the power system, the power system state estimation device 3, the power system information collecting device 26 and the power system control central device 5 are connected to the communication network 27. The configuration of Figure 13 is greatly different from Figure 1 in that the power system control central device 5 and the power state estimation data database DB4 are provided.

Next, the flow of rough processing in the power system using the power system state estimation device 3 will be described. The power system state estimation device 3 performs a state estimation calculation using real-time sensor data or the like obtained via the communication network 27 and outputs power state estimation data of any point of the power system to the power state estimation data database DB4.

The power system control central device 5 calculates the control amount of each device constituting the power system, using the power state estimation data stored in the power state estimation data database DB4 and gives a control command to each device via the communication network 27, based on the control amount. Each device constituting the power system performs a control operation according to the control command given from the power system control central device 5.

Subsequently, the content or function of each of the remaining parts constituting the power system using the power system state estimation device 3 will be described.

The power state estimation data database DB4 is power state estimation data of any point of the power system outputted from the power system state estimation device 3. The power state estimation data database DB4 includes, for example, the active power, reactive power, voltage and phase of each node, and the active power, reactive power and current of each branch, etc.

The power system control central device 5 calculates the control amount of each device constituting the power system using the power state estimation data 4 and gives a control command to each device via the communication network 27, based on the control amount.

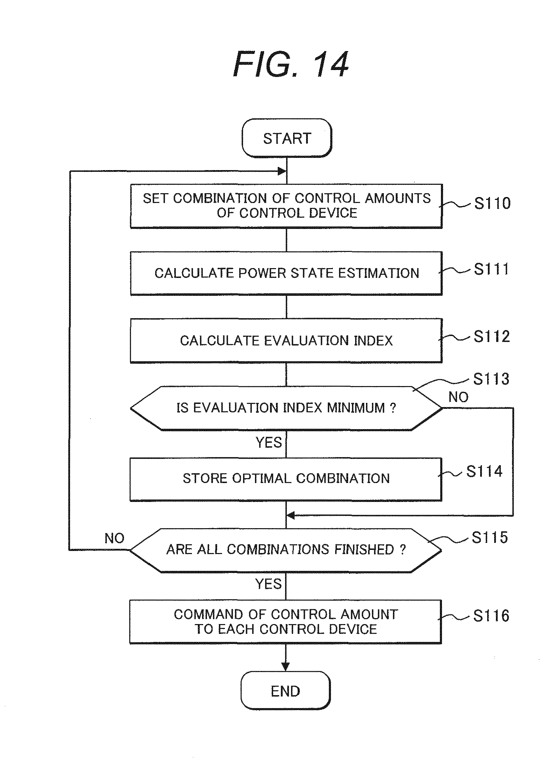

Here, an example of a method for calculating the control amount of each device constituting the power system will be explained using a flowchart of Figure 14.

First, a controllable device connected to the power system is extracted. In the example of Figure 13, there are shown three in total, for example, a substation (transformer thereof) 20a and voltage adjusting devices 25a and 25b. Of these devices, the transformer of the substation and SVR (Step Voltage Regulator) are devices each of which regulates the voltage with each tap and controls the voltage by selecting one of a plurality of tap positions. Therefore, candidates for the control amount are provided by the number of taps. Further, SVC (Static Var Compensator) is a device capable of freely outputting reactive power within the range of capacity. In that sense, the candidates for the control amount are provided continuously. When, however, the candidates for the control amount are determined in a predetermined amount of pitch width, a plurality of control amount candidates exist similarly to the transformer of the substation and SVR.

For example, under the premise that controllable devices are those described above, in first Step S110, all combinations of control amount candidates for these devices are set.

Next, in Step S111, in a certain combination, the power state estimation value of the power system when the control amount is commanded is calculated. Upon its calculation, the function of the state estimation unit 32 is used.

Next, in Step S112, an evaluation index is calculated. The evaluation index is calculated using the results obtained by the state estimation calculation, but as the evaluation index, for example, the sum of the amount of power loss and the amount of deviation from the specified range of the voltage in the power system, etc. are exemplified. It is desirable to minimize such an evaluation index in terms of the efficiency of power transmission and distribution and power quality.

Next, in Step S113, the evaluation index is compared to the current evaluation index minimum value. In this case, the evaluation index minimum value (initial value) in the first combination may be taken as an extremely large value on the assumption that it is updated.

As a result of the comparison, when the calculated evaluation index is smaller than the current evaluation index minimum value (Yes in Step S113), the corresponding control amount combination is stored in Step S114, and the evaluation index minimum value is updated to this evaluation index.

When the calculated evaluation index is not smaller than the current evaluation index minimum value (No in Step S113), the flowchart proceeds to Step S115.

Next, in Step S115, a check is made as to whether all combinations have been finished. If all the combinations are not finished (No in Step S115), the flowchart returns to Step S110 to continue the processing.

If all the combinations are finished (Yes in Step S115), the flowchart proceeds to Step S116 where the power system control central device refers to the control amount combination that is the currently-stored evaluation index minimum value and issues a control amount command to each control device.

If done as mentioned above, it is possible for the power system control central device 5 to determine the optimum control amount of each control device using the output of the power system state estimation device 3. As a result, it is possible to reduce the amount of power loss in the power system and the amount of deviation from the specified range of the voltage and maintain the quality of power.

Reference Signs List

    DB1: power system data database,
    DB2: sensor data database,
    3: power system state estimation device,
    30: estimation environment setting unit,
    DB3: estimated environment data database,
    32: state estimation unit,
    20a: substation transformer (node),
    20b - 20h: utility poles (nodes),
    21: transmission/distribution line (branch),
    22: sensor,
    23: pole transformer,
    24: customer (node),
    25: voltage adjusting device,
    26: power system management device,
    27: communication network,
    80 and 81: groups of sensors classified by clustering,
    DB4: power state estimation data database,
    5: power system control central device, and
    120: power state by linear interpolation.

**Claims**

1. A power system state estimation device having a plurality of sensors disposed in respective points of a power system and estimating a state of the power system using the output of the sensors, comprising:

    a power system data database which holds node information indicative of positions in the power system and facility information including the sensors in association with each other;

a sensor data database which holds the output of the sensors therein;

an estimation environment setting unit which determines a sensor to be used when a power state at a particular node is estimated, using the information of the power system data database; and

a state estimation unit which in correspondence to the sensor used at the particular node determined by the estimation environment setting unit, obtains the output of the sensor from the sensor data database and performs state estimation for the entire power system,

wherein the estimation environment setting unit includes a sensor identifying unit for identifying that the sensor installed in the power system is a sensor exhibiting a peculiar tendency, and a sensor changing unit for changing a sensor used at a node corresponding to the identified sensor.

2. The power system state estimation device according to claim 1,
wherein the sensor changing unit for changing the sensor takes a sensor set to a node immediately upstream of the corresponding node to be the sensor for the corresponding node.

3. The power system state estimation device according to claim 1,
wherein the sensor identifying unit for identifying that the sensor is the sensor exhibiting the peculiar tendency performs a sensor determination on the basis of the entire power system and a customer type around the sensor.

4. The power system state estimation device according to claim 1,
wherein the sensor identifying unit for identifying that the sensor is the sensor exhibiting the peculiar tendency performs a sensor determination by clustering based on the measured power state.

5. The power system state estimation device according to claim 1,
wherein the sensor identifying unit for identifying that the sensor is the sensor exhibiting the peculiar tendency sets a plurality of combinations of sensors, takes a sensor determined from a combination of sensors closest in average and variation to the entire distribution lines on the basis of the power state measured in each combination to be a sensor used in the state estimation unit, and determines each of sensors other than the sensor as the sensor exhibiting the peculiar tendency.

6. The power system state estimation device according to claim 1,
wherein the sensor identifying unit for identifying that the sensor is the sensor exhibiting the peculiar tendency sets a plurality of combinations of sensors, calculates a power state at an evaluation point of the power system on the basis of the power state measured in each combination, selects a combination in which a deviation between the calculated value at the evaluation point and measurement data becomes a predetermined value or less, takes a selected sensor to be the sensor used in the state estimation unit, and determines each of sensors other than the sensor as the sensor exhibiting the peculiar tendency.

7. The power system state estimation device according to claim 1,
wherein the sensor identifying unit for identifying that the sensor is the sensor exhibiting the peculiar tendency is run for each day of the week or time zone or for each magnitude of load power flowing through the power system.

8. The power system state estimation device according to claim 1,
wherein the power state is at least one of the current, voltage, power factor, active power and reactive power.

9. A power system including a plurality of sensors disposed in respective points of a power system, a power state control device disposed in each point of the power system and capable of controlling a power state of the power system, a power system state estimation device which estimates a power system state using the output of the sensors, and a power system control central device which provides an operation signal to the power state control device in response to the power system state from the power system state estimation device,
wherein the power system state estimation device includes
a power system data database which holds node information indicative of positions in the power system and facility information including the sensors in association with each other,
a sensor data database which holds the output of the sensors therein,
an estimation environment setting unit which determines a sensor to be used when a power state at a particular node is estimated, using the information of the power system data database, and
a state estimation unit which in correspondence to the sensor used at the particular node determined by the estimation environment setting unit, obtains the output of the sensor from the sensor data database and performs state estimation for the entire power system, and

the estimation environment setting unit includes a sensor identifying unit for identifying that the sensor installed in the power system is a sensor exhibiting a peculiar tendency, and a sensor changing unit for changing a sensor used at a node corresponding to the identified sensor.

## FIG. 1

## FIG. 2

## FIG. 3

21a(1)  21b(2)  21c(3)  21d(4)  21e(5)  21f(6)  21g(7)

20a(1)  20b(2)  20c(3)  20d(4)  20e(5)  20f(6)  20g(7)  20h(8)

21h(8)

24a(9)

21i(9)

24b(10)

## FIG. 4

| NODE NO. | DISTANCE [m] FROM SUBSTATION | NODE NAME | FACILITY INFORMATION | | | | |
| --- | --- | --- | --- | --- | --- | --- | --- |
| | | | SUB-STATION 20 | SEN-SOR 22 | POLE TRANS-FORMER 23 | CUSTOM-ER 24 | VOLTAGE ADJUSTING DEVICE 25 |
| 1 | 0 | 20a | 20a | 22e | 0 | 0 | 0 |
| 2 | 500 | 20b | 0 | 0 | 0 | 0 | 0 |
| 3 | 1000 | 20c | 0 | 22a | 0 | 0 | 0 |
| 4 | 1500 | 20d | 0 | 0 | 23a | 0 | 0 |
| 5 | 2000 | 20e | 0 | 22b | 0 | 0 | 25a |
| 6 | 2500 | 20f | 0 | 22c | 0 | 0 | 0 |
| 7 | 3000 | 20g | 0 | 0 | 23b | 0 | 0 |
| 8 | 3500 | 20h | 0 | 22d | 0 | 0 | 25b |
| 9 | 1700 | 24a | 0 | 0 | 0 | 24a | 0 |
| 10 | 3250 | 24b | 0 | 0 | 0 | 24b | 0 |

# FIG. 5

| BRANCH NO. | BRANCH NAME | START NODE | END NODE | R[Ω] | X[Ω] |
|---|---|---|---|---|---|
| 1 | 21a | 1 | 2 | 0.05 | 0.07 |
| 2 | 21b | 2 | 3 | 0.04 | 0.06 |
| 3 | 21c | 3 | 4 | 0.06 | 0.08 |
| 4 | 21d | 4 | 5 | 0.06 | 0.08 |
| 5 | 21e | 5 | 6 | 0.06 | 0.08 |
| 6 | 21f | 6 | 7 | 0.06 | 0.08 |
| 7 | 21g | 7 | 8 | 0.06 | 0.08 |
| 8 | 21h | 4 | 9 | 0.02 | 0.03 |
| 9 | 21i | 7 | 10 | 0.02 | 0.03 |

# FIG. 6

| TIME | SENSOR ID | CURRENT [A] | | | VOLTAGE [V] | | | POWER FACTOR | | |
|---|---|---|---|---|---|---|---|---|---|---|
| | | A PHASE | B PHASE | C PHASE | AB PHASE | BC PHASE | CA PHASE | A PHASE | B PHASE | C PHASE |
| 0:00 | 22e | 105 | 105 | 105 | 6700 | 6700 | 6700 | 0.98 | 0.98 | 0.98 |
| 0:00 | 22a | 100 | 105 | 97 | 6705 | 6720 | 6690 | 0.63 | 0.61 | 0.59 |
| 0:00 | 22b | 70 | 73 | 65 | 6705 | 6720 | 6690 | 0.98 | 0.98 | 0.98 |
| 0:00 | 22c | 35 | 37 | 36 | 6660 | 6690 | 6660 | 0.50 | 0.51 | 0.48 |
| 0:00 | 22d | 10 | 12 | 8 | 6630 | 6645 | 6615 | 0.96 | 0.95 | 0.95 |
| 0:30 | 22e | 105 | 105 | 105 | 6700 | 6700 | 6700 | 0.98 | 0.98 | 0.98 |
| 0:30 | 22a | 100 | 104 | 99 | 6705 | 6705 | 6690 | 0.64 | 0.62 | 0.60 |
| 0:30 | 22b | 69 | 73 | 66 | 6705 | 6705 | 6690 | 0.99 | 0.98 | 0.98 |
| 0:30 | 22c | 34 | 37 | 35 | 6660 | 6690 | 6660 | 0.51 | 0.52 | 0.49 |
| 0:30 | 22d | 9 | 10 | 8 | 6630 | 6630 | 6615 | 0.96 | 0.95 | 0.95 |
| : | : | : | : | : | : | : | : | : | : | : |

## FIG. 7

| NODE NO. | SENSOR ID |
|----------|-----------|
| 1 | 22e |
| 2 | 22e |
| 3 | 22a |
| 4 | 22a |
| 5 | 22b |
| 6 | 22c |
| 7 | 22c |
| 8 | 22d |
| 9 | 22a |
| 10 | 22c |

## FIG. 8

| NODE NO. | SENSOR ID |
|----------|-----------|
| 1 | 22e |
| 2 | 22e |
| 3 | 22a→22e |
| 4 | 22a→22e |
| 5 | 22b |
| 6 | 22c→22b |
| 7 | 22c→22b |
| 8 | 22d |
| 9 | 20a |
| 10 | 22b |

# FIG. 9

| NODE NO. | SENSOR 1 ID | SENSOR 2 ID | WEIGHT OF SENSOR 1 | WEIGHT OF SENSOR 2 |
|---|---|---|---|---|
| 1 | 22e | 0 | 1.0 | 0.0 |
| 2 | 22e | 22a | 0.5 | 0.5 |
| 3 | 22a | 0 | 1.0 | 0.0 |
| 4 | 22a | 22b | 0.8 | 0.2 |
| 5 | 22b | 0 | 1.0 | 0.0 |
| 6 | 22c | 0 | 1.0 | 0.0 |
| 7 | 22c | 22d | 0.3 | 0.7 |
| 8 | 22d | 0 | 1.0 | 0.0 |
| 9 | 22a | 22b | 0.5 | 0.5 |
| 10 | 22c | 22d | 0.3 | 0.7 |

# FIG. 10

AVERAGE POWER FACTOR $P_{fm}$

# FIG. 11

POWER STATE (FOR EXAMPLE, VOLTAGE)

22e

22b

120

Vx

0 — Px

DISTANCE FROM SUBSTATION

# FIG. 12

$i$   $P_i, Q_i$   $G_{ij} + jB_{ij}$   $P_j, Q_j$   $j$

$P_{ij}, Q_{ij}$

$V_i$     $ij$     $V_j$

# FIG. 13

# FIG. 14

```
                    ┌──────────┐
                    │  START   │
                    └────┬─────┘
                         │
    ┌───────────────────►│
    │   ┌────────────────▼───────────────────┐
    │   │ SET COMBINATION OF CONTROL AMOUNTS │─── S110
    │   │        OF CONTROL DEVICE           │
    │   └────────────────┬───────────────────┘
    │                    │
    │   ┌────────────────▼───────────────────┐
    │   │  CALCULATE POWER STATE ESTIMATION  │─── S111
    │   └────────────────┬───────────────────┘
    │                    │
    │   ┌────────────────▼───────────────────┐
    │   │      CALCULATE EVALUATION INDEX    │─── S112
    │   └────────────────┬───────────────────┘
    │                    │              S113
    │            ┌───────▼────────┐    NO
    │         <  IS EVALUATION INDEX MINIMUM ? >────┐
    │            └───────┬────────┘                 │
    │                  YES                          │
    │   ┌────────────────▼───────────────────┐      │
    │   │      STORE OPTIMAL COMBINATION     │ S114  │
    │   └────────────────┬───────────────────┘      │
    │                    │◄───────────────────────────
    │  NO                │                    S115
    └──<  ARE ALL COMBINATIONS FINISHED ? >
                         │
                       YES
        ┌────────────────▼───────────────────┐
        │       COMMAND OF CONTROL AMOUNT    │─── S116
        │        TO EACH CONTROL DEVICE      │
        └────────────────┬───────────────────┘
                         │
                    ┌────▼─────┐
                    │   END    │
                    └──────────┘
```

**INTERNATIONAL SEARCH REPORT**

| International application No. |
| --- |
| PCT/JP2012/070063 |

A. CLASSIFICATION OF SUBJECT MATTER
*H02J3/00*(2006.01)i

According to International Patent Classification (IPC) or to both national classification and IPC

B. FIELDS SEARCHED

Minimum documentation searched (classification system followed by classification symbols)
H02J3/00

Documentation searched other than minimum documentation to the extent that such documents are included in the fields searched
Jitsuyo Shinan Koho 1922–1996 Jitsuyo Shinan Toroku Koho 1996–2012
Kokai Jitsuyo Shinan Koho 1971–2012 Toroku Jitsuyo Shinan Koho 1994–2012

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
| --- | --- | --- |
| X | JP 2008-154418 A (Hitachi, Ltd.), 03 July 2008 (03.07.2008), entire text; all drawings (Family: none) | 1,4-9 |
| A | JP 2006-87177 A (Hitachi, Ltd.), 30 March 2006 (30.03.2006), entire text; all drawings (Family: none) | 1-9 |

☐ Further documents are listed in the continuation of Box C. ☐ See patent family annex.

| | | | |
| --- | --- | --- | --- |
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| 23 August, 2012 (23.08.12) | 04 September, 2012 (04.09.12) |

| Name and mailing address of the ISA/ | Authorized officer |
| --- | --- |
| Japanese Patent Office | |
| Facsimile No. | Telephone No. |

Form PCT/ISA/210 (second sheet) (July 2009)

**EP 2 763 261 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2008072791 A
- JP 2008154418 A
- JP 63073831 A